# EUROPEAN PATENT APPLICATION

(11) **EP 4 299 976 A1**
(43) Date of publication of application: **03.01.2024**
(21) Application number: 23172776.9
(22) Date of filing: 11.05.2023
(51) Int. Cl.: F21V 8/00, G02B 27/01

(54) **A DIGITAL DISPLAY APPARATUS AND METHOD OF ASSEMBLING THE SAME**

(30) Priority: 01.07.2022 GB 202209669
(71) Applicant: Continental Automotive Technologies GmbH, 30165 Hannover (DE)
(72) Inventor: Nowak, Martin Thomas, 339780 Singapore (SG); Sankaralingam, Maharaja, 339780 Singapore (SG); Ong, Junn Yaw, 339780 Singapore (SG)
(74) Representative: Continental Corporation

(57) **Abstract**

A digital display apparatus and method of assembling the same is disclosed. The digital apparatus comprises a light source operable to emit light rays; and a rigid light transporter operable to transmit emitted light rays from the light source towards a viewing area. The digital display apparatus further comprises a flexible optical film operable to extract light rays transmitted through the rigid light transporter towards the viewing area, the flexible optical film further comprises at least one microstructure having a curvature; and the flexible optical film is adhered to a curved surface of the rigid light transporter, with a peak of the curvature of the at least one microstructure opposing the curved surface of the rigid light transporter.

## Description

### Technical Field

This disclosure relates to display apparatus, in particular large sized, curved displays and more in particular display apparatus for use in motor vehicles.

### Background

Display apparatus are commonly used for displaying contents to users. Such display apparatus may be placed under outdoor or indoor condition. Increasingly, digital display apparatus replaces traditional analogue instrument clusters for displaying vehicular information to users.

A common challenge of digital display apparatus in motor vehicle applications is the nature of demanding lighting conditions in a motor vehicle. For example, content displayed will be influenced by uncontrollable external lighting conditions such as sunlight when driving during daytime and dim streetlights when driving during night-time.

For aesthetic reasons and for betterment of user experience, demand for curved digital displays is increasing in the automotive industry. However, existing curved display apparatus are not suitable for use in motor vehicles, due to uncontrollable external lighting influences as explained above. While there are existing displays which uses optics with conical shapes to extract light rays to increase illumination, such conical shapes are usually produced for general consumer electronics, for example monitors or screens which does not address the issues as discussed above for motor vehicle applications.

There is therefore a need to provide a digital display apparatus that overcomes, or at least ameliorates, the problems described above. Furthermore, other desirable features and characteristics will become apparent from the subsequent detailed description and the appended claims, taking in conjunction with the accompanying drawings and this background of the disclosure.

### Summary

A purpose of this disclosure is to ameliorate the problem of implementing curved digital displays for use in motor vehicles, by providing the subject-matter of the independent claims.

Further purposes of this disclosure are set out in the accompanying dependent claims.

The objective of this disclosure is solved by a digital display apparatus for use in a motor vehicle, in which:
a light source operable to emit light rays from an edge of the digital display apparatus; and
a rigid light transporter operable to transmit emitted light rays from the light source towards a viewing area;
wherein
the digital display apparatus further comprises:
a flexible optical film operable to extract light rays transmitted through the rigid light transporter towards the viewing area, the flexible optical film further comprises at least one microstructure having a curvature;
   and
the flexible optical film is adhered to a curved surface of the rigid light transporter, with a peak of the curvature of the at least one microstructure opposing the curved surface of the rigid light transporter.

An advantage of the above-described aspect of this disclosure yields a digital display apparatus including a flexible optical film, in which the flexible optical film is arranged relative to a rigid light transporter such that the flexible optical film extracts light rays from the rigid light transporter to increase illumination towards a viewing area. Preferably, the microstructures are displaced on the flexible optical film strategically to achieve homogeneity.

Preferred is a digital display apparatus as described above or as described above as being preferred, in which:
the flexible optical film has a total thickness ranging between 100*µm to* 400*µm*.

The advantage of the above aspect of this disclosure is to optimize light rays extracted from the rigid light transporter towards the viewing area, to achieve homogeneity.

Preferred is a digital display apparatus as described above or as described above as being preferred, in which:
the at least one microstructure has a height ranging between 5*µm to* 100*µm*.

The advantage of the above aspect of this disclosure is to optimize light rays extracted from the rigid light transporter towards the viewing area, to achieve homogeneity.

Preferred is a digital display apparatus as described above or as described above as being preferred, further comprises:
an optically transparent adhesive deposited between the rigid light transporter and the flexible optical film.

The advantage of the above aspect of this disclosure is to integrate the flexible optical film with the rigid light transporter using an optically transparent adhesive, such that a single piece of thin, curved light guide is produced.

Preferred is a digital display apparatus as described above or as described above as being preferred, in which:
the optically transparent adhesive, the rigid light transporter and the flexible optical film has a matching refractive index.

The advantage of the above aspect of this disclosure is to an integrated light guide, of which all the optical elements share a matching refractive index, to achieve fluid transmission of light rays emitting from the light source through the integrated light guide towards a viewing area.

Preferred is a digital display apparatus as described above or as described above as being preferred, in which:
the viewing area has a size of at least 16 inches and has a curved form factor.

The advantage of the above aspect of this disclosure is to yield a large size, curved display suitable for use in motor vehicles.

Preferred is a digital display apparatus as described above or as described above as being preferred, in which:
each of the at least one microstructure is systematically positioned on the flexible optical film relative to a position of the light source.

The advantage of the above aspect of this disclosure is to distinctively position each of the microstructure on the flexible optical film to optimize homogeneity achievable by the motor vehicle display.

Preferred is a digital display apparatus as described above or as described above as being preferred, in which:
a lower count of the at least one microstructure positioned nearer to the position of the light source; and
a higher count of the at least one microstructure positioned nearer to the position of the light source.

The advantage of the above aspect of this disclosure is to yield a flexible optical film having distinctively or systematically positioned microstructures, thereby achieving optimization of homogeneity. By way of example, at areas where light rays enter the integrated light guide, a lower count of microstructures, i.e., lesser number of microstructures may be required to extract light rays towards the viewing area. In contrast, areas further away from light source where light rays are expected to transmit further, a higher number of microstructures may be required to extract light rays towards the viewing area. Consequently, homogeneity is achieved. The aforesaid configuration is useful for edge-lit digital display apparatus.

Preferred is a digital display apparatus as described above or as described above as being preferred, in which:
the rigid light transporter has a curved form factor, the curved form factor of the rigid light transporter approximately the same as the curved form factor of the viewing area.

The advantage of the above aspect of this disclosure is to yield a curved rigid light transporter having a curve radius approximately matching to a display radius of a curved digital display apparatus.

The objective of this disclosure is solved by a method of assembling a digital display apparatus as disclosed herein, comprising:
fabricating a mould for producing at least one flexible optical film comprising the steps of:
laying a metal sheet for framing a flexible optical film on a flat plane; and
producing, by way of lasering, at least one microstructure on the metal sheet;
   wherein
the at least one microstructure lasered comprises a curvature.

An advantage of the above-described aspect of this disclosure yields a master mould for fabricating one or more flexible optical film as discussed herein, which is suitable for reproducing the flexible optical film on a flat panel, to achieve even and symmetrical microstructures in the master mould.

Preferred is a method of assembling a digital display apparatus as described above or as described above as being preferred, further comprising:
producing at least one flexible optical film, by way of the mould fabricated, through an injection moulding process.

The advantage of the above aspect of this disclosure is to produce the flexible optical film though an injection moulding process using the master mould fabricated.

Preferred is a method of assembling a digital display apparatus as described above or as described above as being preferred, further comprising:
providing a rigid light transporter, the rigid light transporter having a curve radius ranging from preferably 0mm to 4000mm, more preferably 500 - 4000mm, and even more preferably, 1000mm to 3000mm.

The advantage of the above aspect of this disclosure is to provide a rigid light transporter with a curved radius.

Preferred is a method of assembling a digital display apparatus as described above or as described above as being preferred, in which:
depositing an optically transparent adhesive on a curved surface of the rigid light transporter; and
adhering the at least one flexible optical film produced onto the curved surface of the rigid light transporter.

The advantage of the above aspect of this disclosure is to yield an integrated light guide suitable for large size, curved motor vehicle displays.

### Brief Description of Drawings

Other objects and aspects of this disclosure will become apparent from the following description of embodiments with reference to the accompanying drawings in which:
FIG. 1A shows a cross-section view of an integrated light guide in accordance with an exemplary embodiment
FIG. 1B shows a microstructure in accordance with an exemplary embodiment.
FIG. 2 shows a top view of a flexible optical film in accordance with an exemplary embodiment.
FIG. 3 shows a top view of a digital display apparatus in accordance with an exemplary embodiment.
FIG. 4 shows a side cross-section view of a digital display apparatus in accordance with an exemplary embodiment.
FIG. 5A shows flowchart 500a for fabricating a mould for producing a flexible optical film in accordance with an exemplary embodiment.

In various embodiments described by reference to the above figures, like reference signs refer to like components in several perspective views and/or configurations.

FIG. 5B shows flowchart 500b for assembling a digital display apparatus having an integrated light guide in accordance with an exemplary embodiment.

In various embodiments described by reference to the above figures, like reference signs refer to like components in several perspective views and/or configurations.

In various embodiments described by reference to the above figures, like reference signs refer to like components in several perspective views and/or configurations.

### Detailed Description of Embodiments

The following detailed description is merely exemplary in nature and is not intended to limit the disclosure or the application and uses of the disclosure. Furthermore, there is no intention to be bound by any theory presented in the preceding background of the disclosure or the following detailed description. It is the intent of this disclosure to present a digital display apparatus having an integrated light guide to achieve homogeneity. The integrated light guide includes a flexible optical film and a rigid light transporter, of which the integrated light guide is suitable for digital displays.

Hereinafter, the term "transparent" refers to an object or substance having transparent properties. Therefore, the term "optically transparent adhesive" refers to an adhesive having transparent properties, such that light rays are permitted to transmit through. In particular, when used as a means to adhere layers of optical elements together to produce an integrated, single optical element, incident light rays are transmitted through layers of optical elements or the integrated optical element. A type of optically transparent adhesive may be epoxy.

The term "digital display" used herein shall refer to electronic output device for presenting information in visual form. In the context of digital display within a motor vehicle, an example of a digital display includes a full digital dashboard (also known as digital cluster), and a hybrid digital dashboard. When used in the context herein, the term "digital dashboard" shall encompass both full digital dashboard and hybrid digital dashboard unless otherwise specified. The term "digital dashboard" shall refer to full digital instrument clusters which utilises digital display as an output apparatus for displaying vehicular information. The term "hybrid dashboard" shall encompass digital clusters which utilises a combination of analogue and digital electronic components, as a display apparatus for presenting vehicular information. Further, examples of digital display apparatus may include digital display apparatus having display layers fabricated using suitable digital display technologies. Example of digital display layers may include liquid crystal displays (LCD) organic light emitting diode (OLED) displays and thin film transistors (TFT) display layers. The term "curve" refers to a line or an outline which gradually deviates from being a straight line, for at least a part of its length. Henceforth, the terms "curve", "curved", "curvature", "curve form" and its variation thereof shall be taken to encompass line or outline as such, including convex and concave line or outline.

The term "display radius" refers to a display curvature or curve form factor of a display, which is measured in millimetres (mm) or denote by 'R'.

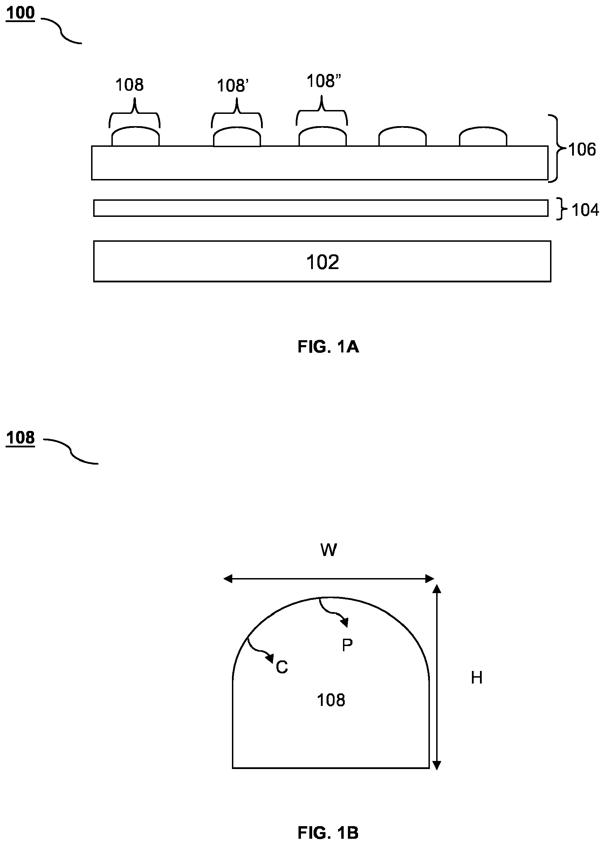

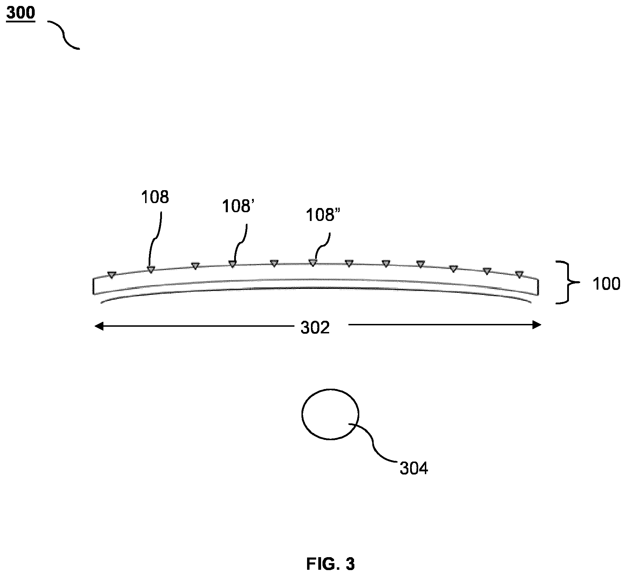

Referring to FIG. 1A of the accompanying drawing, a side, cross-section view of an integrated light guide 100 in accordance with a preferred embodiment is shown. The integrated light guide 100 includes a rigid light transporter 102 and a flexible optical transporter 106. The rigid light transporter 102 is operable to transmit light rays through to a viewing area. The flexible optical transporter 106 comprises at least one microstructure 108, 108', 108", each of the at least one microstructure 108, 108', 108" having a curvature C (FIG. 1B referred). An example of a curvature profile may be a dome. With reference to FIG. 1B which shows an exemplary microstructure 108 in accordance with a preferred embodiment, the microstructure 108 has a height H ranging between 5*µm to* 100*µm* and a width W ranging between 50*µm to* 100*µm*. Turning back to FIG. 1A, the flexible optical film 106 is operable to extract light rays transmitted through the rigid light transporter 102 towards the viewing area 302, as shown in FIG. 3. The at least one microstructure 108, 108', 108" may be disposed on the flexible optical film 106 in a systematic manner.

Although FIG. 1A illustrates a flat panel integrated light guide 100, it shall not be limited thereto, and it shall be understood by a skilled practitioner the same inventive concept may be applied to produce integrated light guides in curved form. For example, the rigid light transporter 102 may have a curved form factor, such that light rays transmitted through to the viewing area 302 has a curved form factor as shown on FIG. 3, to implement an integrated light guide as disclosed herein, to a curved digital display apparatus. In some embodiments disclosed herein, the rigid light transporter has a curve radius ranging from preferably 0mm to 4000mm, more preferably 500 - 4000mm, and even more preferably, 1000mm to 3000mm. In some embodiments disclosed herein, the rigid light transporter has a curve radius of infinity, ∞, denoting a substantially flat surface or flat panel.

To produce an integrated light guide 100, an optically transparent adhesive 104 may be applied to a side of the rigid light transporter 102. If the rigid light transporter 102 has a curved form factor or in other words, a curved rigid light transporter 102 is used, the optically transparent adhesive 104 is applied to a convex surface of the rigid light transporter 102. Henceforth, the integrated light guide 100 produced includes a flexible optical film 106 having at least one microstructure 108, 108' and 108" systematically positioned, each of the microstructure 108, 108', 108" having a curvature C, with a peak P of the curvature C of the at least one microstructure 108, 108', 108" opposing the curved surface of the rigid light transporter 102. Preferably, the optically transparent adhesive 104, the rigid light transporter 102 and the flexible optical film 106 has a matching refractive index, such that light rays may be transmitting though the integrated light guide 100.

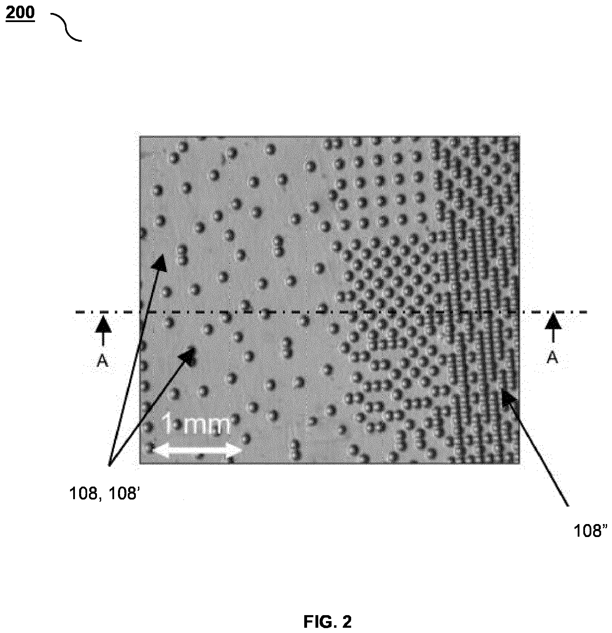

FIG. 2 shows a top view of a flexible optical film 106 in accordance with an exemplary embodiment. As can be seen from FIG. 2, at least one microstructure 108, 108', 108" is systematically positioned on a surface of the flexible optical film 106. Each of the at least one microstructure 108, 108', 108" has a curvature profile or a dome-like microstructure with a peak P. Preferably, the flexible optical film 106 has a total thickness ranging between 100*µm to* 400*µm*. The flexible optical film 106 may be polish, ed to produce a mirror polished surface quality. In this exemplary embodiment, the at least one microstructure 108, 108', 108" are positioned such that one side of the flexible optical film 106 has a plurality of microstructures 108, 108', 108" sparsely scattered on the flexible optical film while the other end of the flexible optical film 106 a plurality of microstructures 108, 108', 108" are densely scattered. The aforesaid configuration is suitable for edge-lit digital displays where the flexible optical film 106 has a lower count of the at least one microstructure positioned nearer to a position of a light source, i.e., microstructures are sparsely scattered, and a higher count of the at least one microstructure positioned nearer to the position of the light source, i.e., microstructures are densely scattered.

A main advantage of the flexible optical film 106 as disclosed herein is the total thickness of the flexible optical film 106 ranges between 100*µm to* 400*µm*, thus yielding thin integrated light guide, therefore a total thickness of digital display apparatus is also reduced. Another advantage of the flexible optical film 106 disclosed is that shape accuracy, i.e., curvature of each of the at least one microstructure 108, 108', 108" may be produced, as a result of the flexible optical film 106 being produced on a flat panel in contrast with moulding microstructure directly on the light guide itself. Yet another advantage is that the flexible optical film 106 may be applied on curved rigid light transporter of any radius or curve form factor. Naturally, the microstructures 108, 108', 108" orientates to a curve surface of the rigid light transporter, reducing distortion of the microstructures 108, 108', 108".

FIG. 3 shows a top view of a digital display apparatus 300 in accordance with an exemplary embodiment. In this exemplary embodiment, the digital display apparatus 300 is a large size, curved display apparatus, with a viewing area 302. The viewing area 302 is operable to display content or information. Preferably, the viewing area has a size of at least 16 inches and has a curved form factor. In this exemplary embodiment, the rigid light transporter 102 has a curved form factor, the curved form factor of the rigid light transporter 102 approximately matching to the curved form factor of the viewing area 302. The digital display apparatus 300 includes an integrated light guide 100. As can be seen from FIG. 3, the flexible optical film 106 is positioned furthest away from the viewing area 3002, or backward of the rigid light transporter 102. Preferably, the rigid light transporter has a curved form factor, the curved form factor of the rigid light transporter 102 approximately matching to the curved form factor of the viewing area.

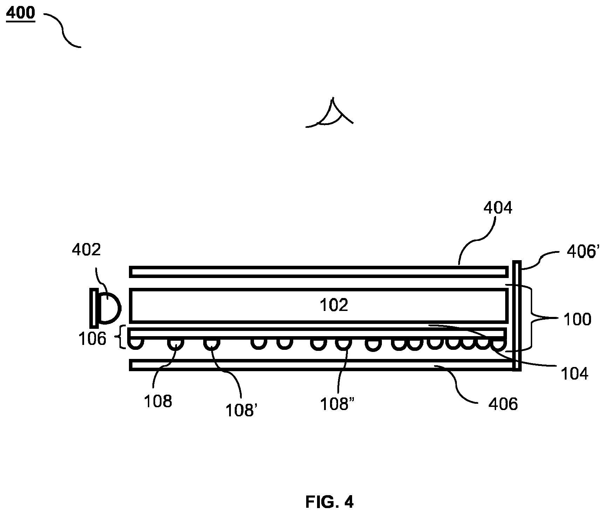

FIG. 4 shows a side cross-section view of a digital display apparatus 400 in accordance with an exemplary embodiment. The digital display apparatus 400 includes an Illumination source 402 operable to emit light rays, an integrated light guide 100 comprising a rigid light transporter 106 to transmit light rays emitted from the illumination source 402. In this exemplary embodiment, the illumination source 402 is arranged on an edge of the digital display 400. The integrated light guide 100 further comprises a flexible optical film 106 operable to extract light rays transmitted through the rigid light transporter towards the viewing area, the flexible optical film 106 further comprises at least one microstructure having a curvature C.

Optionally, an optical film diffusor 404 may be placed forward of the rigid light guide 102. Optionally, the optical elements are placed within a housing of a digital display apparatus, applied with reflector foil 406, 406' to optimise reflection of light rays within an ambient of a digital display apparatus 400, to be extracted by the flexible optical film 106 and transmitted through the rigid light transporter 102, towards a viewing area.

### Method of Moulding

In an exemplary embodiment, a master mould may be fabricated, for producing the flexible optical film 106 and producing an integrated light guide 100 as disclosed herein.

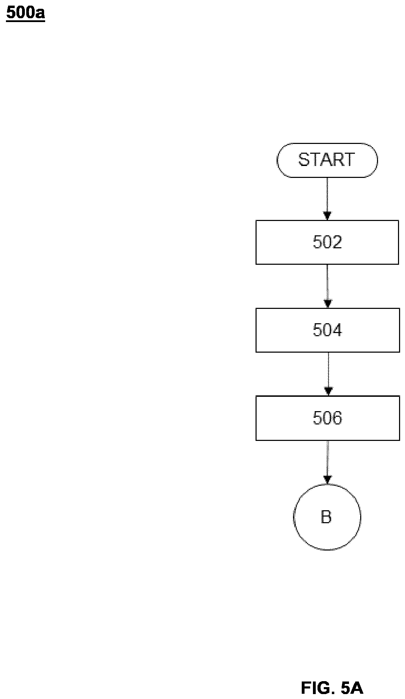

FIG. 5A shows flowchart 500a for fabricating a mould for producing the flexible optical film 106. At step 502, a metal sheet is laid on a flat plane. At a next step 504, lasering is applied to the metal sheet to produce at least one microstructure 108, 108' or 108", the microstructure 108, 108' or 108" having a curvature C. Consequently, a master mould is produced. At step 506, at least one flexible optical film 106 may be produced using the master mould fabricated from steps 502 and 504, by applying injection moulding process.

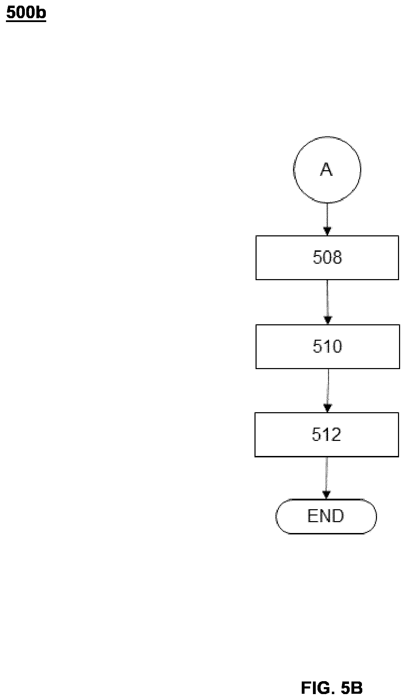

Referring now to FIG. 5B which shows flowchart 500b for assembling a digital display apparatus 300, 400, at a step 508, a rigid light transporter for transmitting light rays through the digital display apparatus 300, 400 to a viewing area is provided. In a preferred embodiment, the rigid light transporter may be a flat panel, for producing a flat panel digital display apparatus. In a preferred embodiment, the rigid light transporter possesses a curved form factor or a display radius, for producing a curved display apparatus.

At step 510, an optically transparent adhesive is applied or deposited on the rigid light transporter. In a preferred embodiment where the rigid light transporter has a curved form factor, the optically transparent adhesive is applied or deposited on a curved side of the rigid light transporter. At step 512, the at least one optical film produced is adhered to a side of the rigid light transporter. More specifically, the at least one optical film produced is adhered to a curved side of the rigid light transporter, thereby producing an integrated light guide for assembling a digital display apparatus.

A known method of producing conical shaped optical elements within layers of displays is to apply lasering techniques directly on a light guide such that the conical-shaped optical elements are produced on the light guide itself. However, if the display is a curved display and a curved light guide is used, the resultant conical shaped optical elements produced may be inconsistent, with distortion of cavities and lens on the light guide element. A main advantage of producing a master mould for fabricating a flexible optical film to be adhered to a rigid light transporter aims to ameliorate the aforesaid problem.

Thus, it can be seen that a large, curved digital display apparatus having an integrated light guide which achieves homogeneity has been provided. In particular, the integrated light guide is produced using a combination a flexible optical film and a rigid light transporter. In addition, the flexible optical film includes at least one microstructure with a curvature to extract light rays which passes through to the rigid light guide for transmitting light rays towards the viewing area of the large, curved digital display apparatus, thereby optimizing light rays being transmitted through to the viewing area. Further thereto, in contrast with conventional method which apply lasering method directly to a curved light transporter to produce structures for extracting light rays to achieve homogeneity, which may result in distorted structures due to fabricating of structures on a curved surface, the present disclosure proposes to at least ameliorate the problems as discussed above by using a flexible optical film that may be adhered to a rigid light transporter. While exemplary embodiments have been presented in the foregoing detailed description of the disclosure, it should be appreciated that a vast number of variation exist.

It should further be appreciated that the exemplary embodiments are only examples, and are not intended to limit the scope, applicability, operation or configuration of the disclosure in any way. Rather, the foregoing detailed description will provide those skilled in the art with a convenient road map for implementing an exemplary embodiment of the disclosure, it being understood that various changes may be made in the function and arrangement of elements and method of operation described in the exemplary embodiment without departing from the scope of the disclosure as set forth in the appended claims.

### List of Reference Signs

| | |
|---|---|
| 100 | Integrated light guide |
| 102 | Rigid light transporter |
| 104 | Optically transparent adhesive |
| 106 | Flexible optical film |
| 108, 108', 108" | At least one microstructure |
| 200 | Top view of flexible optical film |
| 300 | Top perspective view of digital display apparatus |
| 302 | Viewing area |
| 304 | Viewer |
| 400 | Cross section view of digital display apparatus |
| 402 | Illumination source |
| 404 | optical film diffusor |
| 406 | Reflector foil |
| 500a | Flowchart for fabricating a flexible optical film |
| 502 | Laying a metal sheet for framing |
| 504 | Producing at least one microstructure on the metal sheet |
| 506 | Producing at least one flexible optical film using master mould |
| 500b | Flowchart for assembling a digital display apparatus |
| 508 | Providing a rigid light transporter |
| 510 | Depositing an optically transparent adhesive on a rigid light transporter |
| 512 | Adhering the at least one flexible optical film onto a side of the rigid transporter |

## Claims

1. A digital display apparatus (300, 400) for use in a motor vehicle, the digital display apparatus (300, 400) comprising:
a light source (402) operable to emit light rays; and
a rigid light transporter (102) operable to transmit emitted light rays from the light source (402) towards a viewing area (302);
wherein
the digital display apparatus (300, 400) further comprises:
a flexible optical film (106) operable to extract light rays transmitted through the rigid light transporter (102) towards the viewing area (302), the flexible optical film (106) further comprises at least one microstructure (108, 108', 108") having a curvature (C);
and
the flexible optical film (106) is adhered to a curved surface of the rigid light transporter (102), with a peak (P) of the curvature (C) of the at least one microstructure (108, 108', 108") opposing the curved surface of the rigid light transporter (102).

2. The digital display apparatus (300, 400) according to claim 1, wherein the flexible optical film (106) has a total thickness ranging between 100*µm to* 400*µm*.

3. The digital display apparatus (300, 400) according to claims 1 to 2, wherein the at least one microstructure (108, 108', 108") has a height (H) ranging between 5*µm to* 100*µm*.

4. The digital display apparatus (300, 400) according to claims 1 - 2 or 3, wherein the at least one microstructure (108, 108', 108") has a width (W) ranging between 50*µm to* 100*µm*.

5. The digital display apparatus (300, 400) according to claim 1, further comprises an optically transparent adhesive (104) deposited between the rigid light transporter (102) and the flexible optical film (106).

6. The digital display apparatus (300, 400) according to claim 5, wherein the optically transparent adhesive (104), the rigid light transporter (102) and the flexible optical film (106) has a matching refractive index.

7. The digital display apparatus (300, 400) according to any of the preceding claims, wherein the viewing area (302) has a size of at least 16 inches and has a curved form factor.

8. The digital display apparatus (300, 400) according to any one of the preceding claims, wherein
each of the at least one microstructure (108, 108', 108") is systematically positioned on the flexible optical film (106) relative to a position of the light source (402).

9. The digital display apparatus (300, 400) according to claim 8, wherein the flexible optical film (106) comprises:
a lower count of the at least one microstructure (108, 108', 108") positioned nearer to the position of the light source (402); and
a higher count of the at least one microstructure (108, 108', 108") positioned nearer to the position of the light source (402).

10. The digital display apparatus (300, 400) according to any one of the preceding claims, wherein
the rigid light transporter (102) has a curved form factor, the curved form factor of the rigid light transporter (102) approximately matching to the curved form factor of the viewing area (302).

11. A method (500b) of assembling a digital display apparatus according to any one of claims 1 to 10, the method (500b) comprising:
fabricating (500a) a mould for producing at least one flexible optical film comprising the steps of:
laying (502) a metal sheet for framing a flexible optical film (106) on a flat plane; and
producing, by way of lasering, at least one microstructure (108, 108', 108") on the metal sheet;
wherein
the at least one microstructure (108, 108', 108") lasered comprises a curvature (C).

12. The method (500b) according to claim 11, further comprising:
producing (506) at least one flexible optical film, by way of the mould fabricated, through an injection moulding process.

13. The method (500b) according to claim 12, further comprising:
providing (508) a rigid light transporter, the rigid light transporter having a curve radius ranging from preferably 0mm to 4000mm, more preferably 500mm to 4000mm , and even more preferably 1000mm to 3000mm.

14. The method (500b) according to claim 13, further comprising:
depositing (510) an optically transparent adhesive on a curved surface of the rigid light transporter; and
adhering (512) the at least one flexible optical film produced onto the curved surface of the rigid light transporter.
